# EUROPÄISCHE PATENTANMELDUNG

(11) **EP 2 706 562 A2**
(43) Veröffentlichungstag der Anmeldung: **12.03.2014**
(21) Anmeldenummer: 13195922.3
(22) Anmeldetag: 01.09.2009
(51) Int. Cl.: H01L 21/67, H01L 21/683

(54) **Vorrichtung und Verfahren zum Ablösen eines Halbleiterwafers von einem Trägersubstrat mittels Kippens eines Filmrahmens**

(62) Teilanmeldung aus: 09011198.0
(71) Anmelder: EV Group GmbH, 4782 St. Florian am Inn (AT)
(72) Erfinder: Lindner, Friedrich Paul, 4780 Schärding (AT); Burggraf, Jürgen, 4780 Schärding (AT)
(74) Vertreter: Schweiger, Johannes

(57) **Zusammenfassung**

Die Erfindung betrifft eine Vorrichtung zum Ablösen eines Produktsubstrats (Halbleiterwafers) (4) von einem mit dem Produktsubstrat (4) durch eine Verbindungsschicht (6) verbundenen Trägersubstrat (2) mittels eines auf einem Filmrahmen (1) montierten flexiblen Films (3), der eine Klebeschicht (3s) zur Aufnahme des Produktsubstrats (4) in einem Kontaktierungsflächenabschnitt (3k) des Films (3) umfasst, wobei der Film (3) in einem den Kontaktierungsflächenabschnitt (3k) umgebenden Befestigungsabschnitt (3b) des Films (3) auf dem Filmrahmen (1) montiert ist, und wobei der Film (3) einen zwischen dem Kontaktierungsflächenabschnitt (3k) und dem Befestigungsabschnitt (3b) liegenden Ablöseabschnitt (3a) umfasst, wobei die Vorrichtung Ablösemittel zur Bewirkung einer Ablösung des Produktsubstrats (4) vom Trägersubstrat (2) von einem Umfang (4u) des Produktsubstrats (4) her aufweist, und wobei eine Aufnahmeeinrichtung zur Einleitung einer Kraft in den Filmrahmen (1) ein Kippen des Filmrahmens (1) zulassend ausgebildet ist.

Weiterhin betrifft die Erfindung ein entsprechendes Ablöseverfahren.

## Beschreibung

Die Erfindung betrifft eine Vorrichtung gemäß Anspruch 1 und ein Verfahren gemäß Anspruch 9 zum Ablösen eines Produktsubstrats von einem Trägersubstrat.

Das Rückdünnen von Produktsubstraten ist in der Halbleiterindustrie häufig erforderlich und kann mechanisch und/oder chemisch erfolgen. Zum Rückdünnen werden die Produktsubstrate in der Regel auf einen Träger vorübergehend fixiert, wobei es für die Fixierung verschiedene Methoden gibt. Als Trägermaterial werden beispielsweise Folien, Glassubstrate oder Siliziumwafer verwendet.

In Abhängigkeit von den verwendeten Trägermaterialien und der verwendeten Verbindungsschicht zwischen Träger und Produktsubstrat sind verschiedene Verfahren zur Auflösung oder Zerstörung der Verbindungsschicht bekannt, wie beispielsweise die Verwendung von UV-Licht, Laserstrahlen, Temperatureinwirkung oder Lösungsmittel.

Das Ablösen stellt sich zunehmend als einer der kritischsten Prozessschritte dar, da die dünnen Substrate mit Substratdicken von wenigen µm beim Ablösen/Abziehen leicht brechen oder durch die für den Vorgang des Ablösens notwendigen Kräfte Schaden erleiden.

Darüber hinaus haben die dünnen Substrate kaum bis keine Formstabilität und rollen sich typischerweise ohne Stützmaterial ein. Während der Handhabung der rückgedünnten Wafer ist mithin eine Fixierung und Unterstützung der Wafer praktisch unumgänglich.

Es ist daher die Aufgabe der vorliegenden Erfindung, eine Vorrichtung und ein Verfahren anzugeben, um ein solches Produktsubstrat möglichst zerstörungsfrei von einem Träger zu lösen.

Diese Aufgabe wird mit den Merkmalen der Ansprüche 1 und 9 gelöst. Vorteilhafte Weiterbildungen der Erfindung sind in den Unteransprüchen angegeben. In den Rahmen der Erfindung fallen auch sämtliche Kombinationen aus zumindest zwei von in der Beschreibung, den Ansprüchen und/oder den Figuren angegebenen Merkmalen. Bei angegebenen Wertebereichen sollen auch innerhalb der genannten Grenzen liegende Werte als Grenzwerte offenbart und in beliebiger Kombination beanspruchbar sein.

Der Erfindung liegt der Gedanke zugrunde, eine gattungsgemäße Vorrichtung beziehungsweise ein gattungsgemäßes Verfahren dadurch weiterzubilden, indem die Elastizität oder Flexibilität eines auf einem Filmrahmen montierten Films genutzt wird, um das Produktsubstrat schonend und vom Rand des Produktsubstrats her abzulösen und zwar durch Verformung des Films, insbesondere in einem Ablöseanschnitt des Films. Auf diese Weise steht das Produktsubstrat unmittelbar nach dem Abtrennen für weitere Prozessschritte zur Verfügung und ist durch den Film und den Filmrahmen geschützt. Viele Prozessschritte können direkt an dem filmrahmenmontierten Produktsubstrat durchgeführt werden.

Mit anderen Worten: Der flexible Film gibt mittels einer am Filmrahmen anliegenden Kraft und die das Produktsubstrat kontaktierende Klebeschicht im Kontaktierungsflächenabschnitt des Films eine Zugkraft auf das Produktsubstrat ab, wodurch das Produktsubstrat von den Trägersubstrat abgelöst, insbesondere abgeschält wird.

Mit Produktsubstrat ist ein Produktsubstrat, beispielsweise ein Halbleiterwafer, gemeint, das üblicherweise auf eine Dicke zwischen 0,5 µm und 250 µm gedünnt ist, wobei die Tendenz zu immer dünneren Produktsubstraten geht. Besonders effektiv arbeitet die vorliegende Erfindung mit Produktsubstraten, die selbst eine ähnliche Flexibilität wie der am Filmrahmen montierte Film aufweisen. Das Produktsubstrat wird bei der erfindungsgemäßen Vorrichtung beziehungsweise dem erfindungsgemäßen Verfahren von dem Trägersubstrat abgeschält, insbesondere konzentrisch vom Umfang des Produktsubstrats ausgehend.

Als Träger wird beispielsweise ein Trägersubstrat mit einer Dicke zwischen 50 µm und 5,000 µm, insbesondere zwischen 500 µm und 1000 µm verwendet.

Als Verbindungsschicht kommt ein Kleber, beispielsweise ein lösbarer Kleber, insbesondere ein Thermoplast in Frage, der beispielsweise selektiv in einem Randbereich des Trägersubstrat-Produktsubstrat-Verbundes, insbesondere in einer Randzone von 0,1 bis 20 mm, aufgebracht wird. Alternativ kann der Kleber vollflächig aufgebracht werden, wobei die Klebkraft im Zentrum durch eine haftreduzierende Schicht, beispielsweise ein Fluorpolymer, vorzugsweise Teflon, reduziert sein kann.

Als Aufnahmeeinrichtung eignet sich besonders ein Chuck, insbesondere ein Spinner Chuck zur Aufnahme des Trägersubstrats, insbesondere mittels Unterdruck, beispielsweise Saugbahnen, Bohrungen oder Saugnäpfen. Alternativ ist eine mechanische Aufnahme, beispielsweise durch seitliche Klammern, denkbar. In einer weiteren, alternativen Ausgestaltung erfolgt die Aufnahme elektrostatisch.

Die Ablösungsmittel umfassen den auf den Filmrahmen montierten Film und eine den Filmrahmen aufnehmende und kraftbeaufschlagende Filmrahmenaufnahme.

Mit Vorteil sind zusätzlich zu den Ablösemitteln Verbindungslösemittel zur zumindest partiellen Lösung der durch die Verbindungsschicht bewirkten Verbindung zwischen dem Trägersubstrat und dem Produktsubstrat vorgesehen.

Soweit die Vorrichtung Heizmittel zur Aufheizung des Trägersubstrat-Produktsubstrat-Verbundes aufweist, die insbesondere in die Trägersubstrataufnahme integriert sind, kann ein thermoplastisch schmelzender Kleber als Verbindungsschicht verwendet werden. Die maximale Heiztemperatur beträgt 250°C, bevorzugt maximal 175°C.

In einer vorteilhaften Ausführungsform der Erfindung ist vorgesehen, dass das Verbindungslösemittel im Wesentlichen erhitzungsfrei arbeitend ausgebildet ist. Auf diese Weise ist es möglich, auf jegliche Heizeinrichtung zu verzichten.

In einer weiteren vorteilhaften Ausführungsform der Erfindung ist vorgesehen, dass das Verbindungslösemittel Fluidmittel, insbesondere ein die Verbindungsschicht selektiv auflösendes Lösungsmittel, zur Lösung der Verbindungsschicht umfasst. Die chemische Auflösung der Verbindungsschicht ist für das Produktsubstrat besonders schonend und bei entsprechender Materialwahl kann die Auflösung auch sehr schnell erfolgen, insbesondere wenn nur Randbereiche des Produktsubstrats mit einer Verbindungsschicht versehen sind, so dass das Lösungsmittel von der Seite her schnell wirken kann. Auf diese Weise kann auf Perforierungen im Trägersubstrat und/oder Produktsubstrat verzichtet werden.

In einer alternativen Ausführungsform der Erfindung ist vorgesehen, dass das Verbindungslösemittel mechanische Trennmittel, insbesondere eine Klinge zum Durchschneiden der Verbindungsschicht, zur Lösung der Verbindungsschicht umfasst. Hierdurch ist eine besonders schnelle Trennung des Produktsubstrats vom Träger möglich. Denkbar ist auch eine Kombination aus mechanischen Trennmitteln und Fluidmitteln.

In einer weiteren alternativen Ausführungsform der Erfindung ist vorgesehen, dass das Verbindungslösemittel eine UV-Lichtquelle zur Lösung der Verbindungsschicht umfasst. Auch diese Ausführungsform ist mit der Ausführungsform der mechanischen Trennmittel und/oder der Ausführungsform mit Fluidmitteln kombinierbar.

Soweit das Verbindungslösemittel, insbesondere ausschließlich, von einem Seitenrand des Produktsubstrat wirkend ausgebildet ist, kann auf eine Einwirkung auf das Produktsubstrat und/oder den Träger von der Oberseite und/oder der Unterseite, insbesondere einem innerhalb des Seitenrandes liegenden Innenbereich des Produktsubstrats, verzichtet werden.

Indem eine Rotationseinrichtung zur Rotation des Trägersubstrats, Produktsubstrats und/oder des Filmrahmens mit dem Film vorgesehen ist, kann auf eine Anordnung der Verbindungslösemittel über den gesamten Umfang des Produktsubstrats verzichtet werden und eine teilweise Beaufschlagung am Umfang des Produktsubstrats ist ausreichend.

Soweit der Ablöseabschnitt außerhalb der Außenkontur des Produktsubstrats liegt und/oder an den Kontaktierungsabschnitt anschließt, ist eine optimale Übertragung der Ablösekraft durch Verformung des Films auf das Produktsubstrat möglich.

Mit Vorteil ist zur Beaufschlagung der Verbindungsschicht mit Fluidmittel zur Aufnahme des Fluidmittels ein am Trägersubstrat oder einer Trägersubstrataufnahme, insbesondere gedichtet, angeschlagener Lösungsmittelbehälter vorgesehen, dessen Oberkante sich zumindest bis zur durch das Produktsubstrat gebildeten Ebene erstreckt. Indem der Lösungsmittelbehälter den Seitenrand beziehungsweise Umfang des Produktsubstrats zumindest teilweise umgreift, ist eine besonders effektive Einwirkung auf die Verbindungsschicht möglich. Weiterhin kann durch die Maßnahme des Umgreifens verhindert werden, dass Fluidmittel aus dem Lösungsmittelbehälter austritt oder UV-LichtIntensität verloren geht. Beim Einsatz von mechanischen Trennmitteln wird vermieden, dass etwaige Verunreinigungen aus dem Lösungsmittelbehälter austreten und das Produktsubstrat verunreinigen. Der Lösungsmittelbehälter kann in vorteilhafter Ausgestaltung im Querschnitt L- oder U-förmig ausgebildet sein.

In einer weiteren vorteilhaften Ausgestaltung der Erfindung ist vorgesehen, dass sich der Lösungsmittelbehälter nur über einen Umfangssektor des Seitenrandes beziehungsweise Umfangs des Produktsubstrats erstreckt. Mit Vorteil erstreckt sich der Lösungsmittelbehälter nur geringfügig über den Seitenrand beziehungsweise Umfang des Trägersubstrats oder Produktsubstrats in Richtung des Produktsubstratzentrums hinein, damit am Trägersubstrat eine Kraft Fs angelegt werden kann. Die Kraft Fs kann auch über den Lösungsmittelbehälter auf das Trägersubstrat übertragen werden.

Gemäß einer vorteilhaften Ausführungsform der Erfindung ist vorgesehen, dass die Ablösung durch eine auf das Trägersubstrat wirkende Kraft Fs und eine entgegen der Kraft Fs gerichteten, auf den Filmrahmen wirkenden Kraft Ff resultiert. Die Vorrichtung kann die Kraft Ff als lokale Kraft, insbesondere punktuell an mindestens einer Stelle des Filmrahmens einleitend ausgebildet sein. Mit Vorteil wird die Kraft Ff auf mehrere Punkte am Umfang des Filmrahmens verteilt eingeleitet, wobei auch unterschiedliche Kräfte eingeleitet werden können und ein Kippen des Filmrahmens gegenüber dem Trägersubstrat bzw. der Trägersubstrataufnahme durch die Vorrichtung bewirkt werden kann.

Indem der Film durch die Kraft Fs und die Kraft Ff im Ablöseabschnitt verformbar, insbesondere spannbar ist, wird eine homogene Kraftverteilung am Umfang des Produktsubstrats je nach der gewünschten Form der Ablösung erreicht.

Gemäß einer weiteren, vorteilhaften Ausführungsform der Erfindung ist vorgesehen, dass durch die Kraft Fs und die Kraft Ff eine Verschiebung des Filmrahmens gegenüber dem Trägersubstrat bewirkbar ist, wobei hierdurch innerhalb des Filmrahmens eine Wanne entsteht, die zur Übertragung von Schallwellen auf das Produktsubstrat und/oder das Lösungsmittel Schallwellenerzeugungsmittel, insbesondere gebildet aus einem in der Wanne aufnehmbaren Fluid und einem in das Fluid getauchten Schallgeber, aufweist. Die Ablösung des Produktsubstrats wird durch die vom Ultra- oder Megaschall erzeugte Kavitation deutlich beschleunigt, so dass das Ablösen wesentlich schonender und gleichzeitig schneller erfolgt.

Mit Vorteil ist weiterhin vorgesehen, dass die Ablösung des Produktsubstrats konzentrisch vom Umfang des Produktsubstrats zum Zentrum des Produktsubstrats erfolgt.

Besonders vorteilhaft ist es, wenn dass das Produktsubstrat während des Ablösevorgangs am Film haftend ausgebildet ist, da damit eine vollflächige Aufnahme und Schutz gewährleistet sind.

Weitere Vorteile, Merkmale und Einzelheiten der Erfindung ergeben sich aus der nachfolgenden Beschreibung bevorzugter Ausführungsbeispiele sowie anhand der Zeichnungen; diese zeigen in:
- Fig. 1a:: Eine schematische Aufsicht auf einen aus Produktsubstrat, Trägersubstrat und Verbindungsschicht bestehenden Substratverbund auf einem Filmrahmen,
- Fig. 1b:: eine schematische Seitenansicht zu Figur 1a mit einer Detailansicht,
- Figur 2:: eine schematische Darstellung der erfindungsgemäßen Vorrichtung beim Ablösen des Produktsubstrats vom Trägersubstrat mit einer Detailansicht,
- Figur 3: eine schematische Darstellung der erfindungsgemäßen Vorrichtung beim Ablösen des Produktsubstrats vom Trägersubstrat mit einer Detailansicht und
- Figur 4:: eine schematische Darstellung einer Ausführungsform der Erfindung.

In den Figuren sind gleiche Bauteile und Bauteile mit der gleichen Funktion mit den gleichen Bezugszeichen gekennzeichnet.

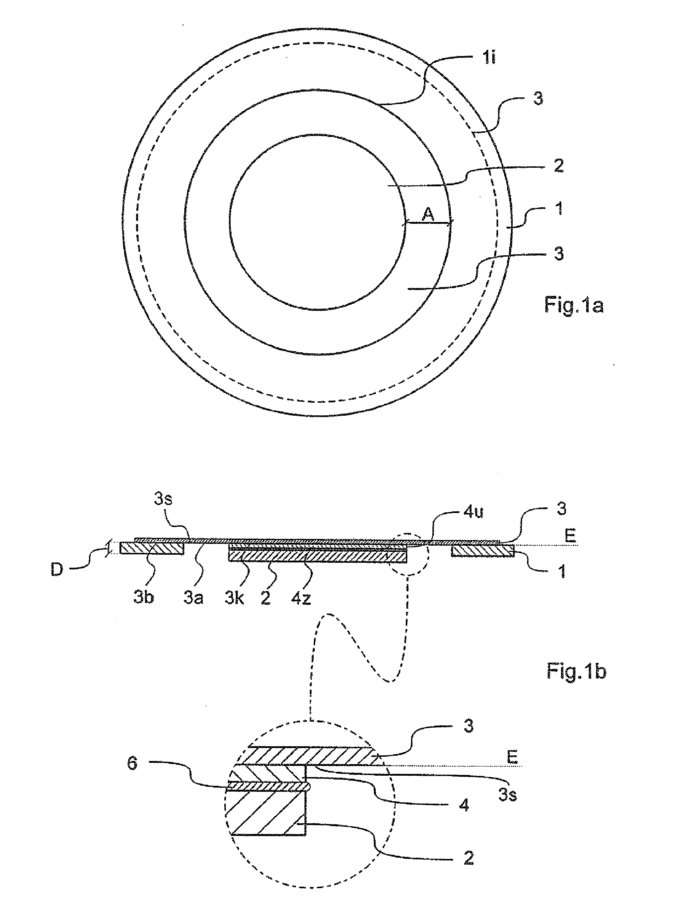

In Figur 1a ist ein in dieser Ausführungsform zumindest an einem Innenumfang 1i kreisrunder Filmrahmen 1 mit einem an dessen Unterseite montierten, insbesondere geklebten, Film 3 dargestellt. Mit Radialabstand zu dem Innenumfang 1i des Filmrahmens 1 ist innerhalb des Filmrahmens 1 ein Produktsubstrat-Trägersubstrat-Verbund auf einer Klebeschicht 3s des Films 3 konzentrisch zu dem Filmrahmen 1 aufgeklebt (siehe Figur 1b).

Der Produktsubstrat-Trägersubstrat-Verbund besteht aus einem am Film 3 haftenden Produktsubstrat 4, einem Trägersubstrat 2 und einer das Produktsubstrat 4 und das Trägersubstrat 2 verbindenden Verbindungsschicht 6. Die Durchmesser des Produktsubstrates 4 und des Trägersubstrates 2 sind im Wesentlichen identisch, während die Dicke des Produktsubstrates 4 geringer ist als die Dicke des Trägersubstrates 2.

Der Film 3 besteht aus einem im vorliegenden Fall kreisringförmigen Befestigungsabschnitt 3b, in welchem der Film 3 mit dem Filmrahmen 1 fixiert ist. Weiterhin besteht der Film 3 aus einem Kontaktierungsflächenabschnitt 3k, in welchem das Produktsubstrat 4 an der Klebeschicht 3s des Films 3 fixierbar ist. Zwischen dem Befestigungsabschnitt 3b und dem Kontaktierungsflächenabschnitt 3k liegt ein, insbesondere konzentrisch zu dem Befestigungsabschnitt 3b und dem Kontaktierungsflächenabschnitt 3k angeordneter Ablöseabschnitt 3a, dem eine erfindungsgemäß entscheidende Funktion zukommt. Der Ablöseabschnitt 3a erstreckt sich damit von einem Umfang 4u des Produktsubstrates 4 bis zu dem Innenumfang 1i des Filmrahmens, vorliegend als Abstand A bezeichnet. Das Verhältnis zwischen einer Dicke D des Filmrahmens 1 und des Abstands A beträgt mit Vorteil mindestens 1 zu 2 bis 1 zu 50, insbesondere 1 zu 5 bis 1 zu 25, bevorzugt 1 zu 19 oder 1 zu 10.

In der in Figur 1b gezeigten Ausgangslage sind die den Film 3 kontaktierende Seite des Produktsubstrates 4 und die den Film 3 kontaktierende Seite des Filmrahmens 1 fluchtend und in einer Ebene E angeordnet. Die in den Figuren 1a und 1b gezeigten Teile werden auf einem bekannten Filmframemounter zusammengebaut.

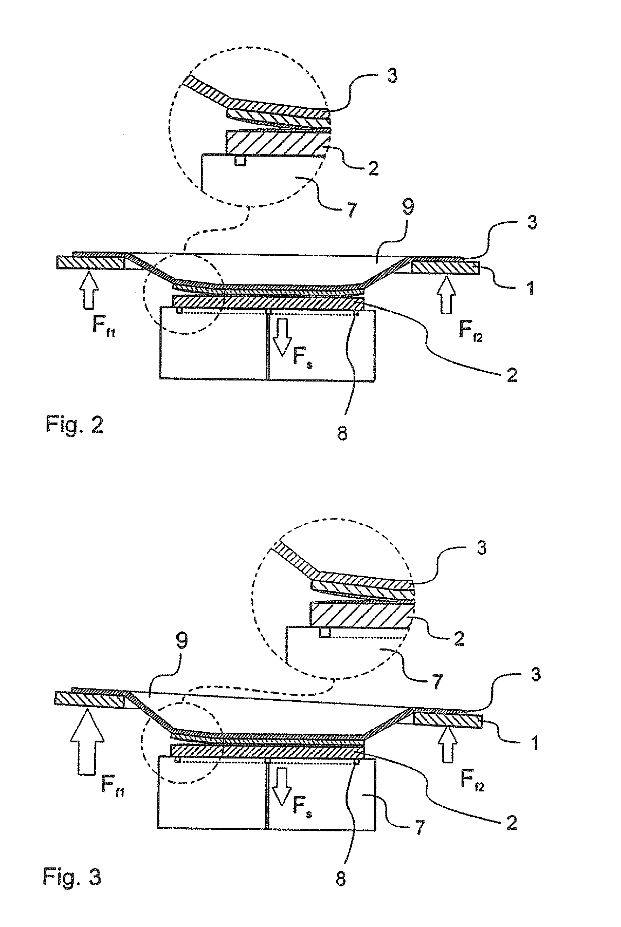

In den Figuren 2 und 3 ist der Ablösevorgang in zwei Varianten schematisch dargestellt, und zwar kurz nach Beginn des Ablösens des Produktsubstrates 2 vom Trägersubstrat 4.

Durch Einleiten entgegenwirkender Kräfte Ff, bzw. Ff1 und Ff2, und Fs wird der Produktsubstrat-Trägersubstrat-Verbund und der daran klebende Kontaktierungsflächenabschnitt 3k des Films 3 aus dem Filmrahmen 1 in Richtung einer Trägersubstrataufnahme 7 bewegt. In kinematischer Umkehr kann auch der Filmrahmen 1 durch die Kraft Ff mittels einer nicht dargestellten Filmrahmenaufnahme, beispielsweise eines Roboterarmes, bewegt werden.

Die Kraftübertragung von der Trägersubstrataufnahme 7 auf das Trägersubstrat 2 erfolgt über in die Oberfläche der Trägersubstrataufnahme 7 eingearbeitete Vakuumbahnen 8 und eine daran angeschlossene, nicht dargestellte Vakuumeinrichtung. Die Trägersubstrataufnahme 7 ist fest mit der Vorrichtung verankert.

Alternativ kann die Aufnahme des Trägersubstrates 2 mechanisch, beispielsweise durch Klemmung, oder elektrostatisch erfolgen.

Die auf den Filmrahmen 1 wirkende Kraft Ff kann - wie in Figur 2 dargestellt - gleichmäßig verteilt als Flächenkraft auf den Filmrahmen 1 wirken, so dass über die Verformung des Ablöseabschnitts 3a die Ablösung des Produktsubstrates 4 von dem Trägersubstrat 2 vom Rand her erfolgt, wie in der Detaildarstellung in Figur 2 vergrößert dargestellt. Die Kraft Ff1 ist dabei mit der Kraft Ff2 identisch. Die Kraft kann punktuell verteilt am Umfang des Filmrahmens 1 eingeleitet werden oder durch eine Filmrahmenaufnahme verteilt eingebracht werden.

Im in Figur 3 dargestellten Ausführungsbeispiel ist die Kraftverteilung am Umfang des Filmrahmens 1 unterschiedlich, und zwar ist die Kraft Ff1 größer als die Kraft Ff2 auf der gegenüberliegenden Seite, so dass das Produktsubstrat 4 zunächst auf der Seite, an der die größere Kraft Ff1 eingeleitet wird, abgelöst wird. Die Aufnahmeeinrichtung zur Einleitung der Kraft in den Filmrahmen 1 muss daher ein Kippen des Filmrahmens 1 zulassend ausgebildet sein.

Das Produktsubstrat 4 fördert das Ablösen, da es sich ähnlich elastisch wie der Film 3 verhält und sich damit vom ProduktsubstratTrägersubstrat-Verbund Schritt für Schritt von dessen Rand her löst.

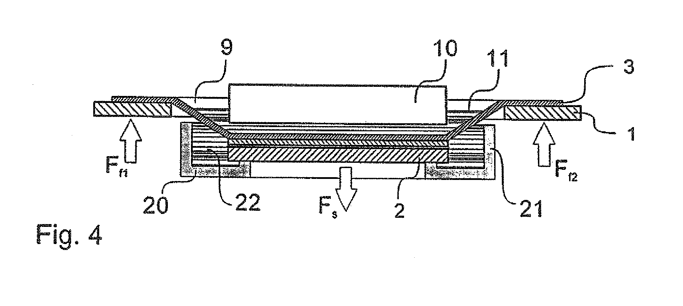

Gemäß Figur 4 ist ein Lösungsmittelbehälter 20 derart an dem Trägersubstrat 2 angeordnet, dass ein Eintauchen des ProduktsubstratTrägersubstrat-Verbundes in der mit Kraft beaufschlagten Stellung des Produktsubstrat-Trägersubstrat-Verbundes ermöglicht wird. Der Lösungsmittelbehälter 20 ist, in vorliegenden Fall ringförmig, am Umfang des Trägersubstrates 2, insbesondere dichtend angebracht, so dass eine Krafteinleitung innerhalb des Lösungsmittelbehälters 20 auf das Trägersubstrat 2 nach wie vor möglich ist. Die Krafteinleitung kann alternativ auch am Lösungsmittelbehälter 20 erfolgen, beispielsweise wenn der Lösungsmittelbehälter 20 kraftschlüssig am Trägersubstrat 2 angebracht ist. Eine äußere Umfangswand 21 des Lösungsmittelbehälters 20 erstreckt sich mindestens bis zu einer durch das Produktsubstrat 4 gebildeten Ebene, damit das Lösungsmittel 22 im Lösungsmittelbehälter 20 mindestens bis zur Verbindungsschicht 6 reicht und diese durch das Lösungsmittel 22 aufgelöst werden kann. Mit Vorteil erstreckt sich die äußere Umfangswand 21 über die durch das Produktsubstrat 4 gebildete Ebene hinaus bis fast zum Filmrahmen 1, damit auch bei einer Rotation ein Austreten des Lösungsmittels 22 aus dem Lösungsmittelbehälter 20 möglichst vermieden wird.

Durch diese Maßnahme wird das Ablösen, insbesondere Abschälen des Produktsubstrates 4 von dem Trägersubstrat 2 unterstützt, indem vom Umfang 4u des Produktsubstrates 4 die Verbindungsschicht 6 aufgelöst wird und durch die Verformung des Films 3 am Umfang 4u anliegende Zugkraft wird das Produktsubstrat 4 schonend abgehoben.

Durch die Verformung des Films 3 entsteht eine Wanne 9. Das Einleiten eines Fluids 11 in die Wanne 9 erfolgt zur Übertragung von Schallwellen (Ultraschall, Megaschall) über den Film 3 in das gegenüberliegend des Films 3 angeordnete Lösungsmittel 22 sowie in den Produktsubstrat-Trägersubstrat-Verbund mittels eines Schallwellenerzeugungsmittels, vorliegend Schallgebers 10. Das Lösungsmittel 22 wirkt durch die Schalleinbringung vom Rand her beschleunigt auf die Verbindungsschicht 6, so dass die Rückstellkraft des Films 3 in Richtung Filmrahmen 1 verringert werden kann und/oder das Ablösen unterstützt wird, insbesondere bei radialsymmetrischen Ablösen gemäß Figur 2.

Durch das Einleiten von Schall werden Lösungsmittelmoleküle des Lösungsmittels 22 in Schwingung versetzt, wodurch es zu Kavitation kommt, was zu einer deutlichen Beschleunigung der Auflösung der Verbindungsschicht 6 führt.

Das Lösungsmittel 22 ist mit Vorteil selektiv auf die Verbindungsschicht 6 abgestimmt und die Klebeschicht 3s ist von dem Lösungsmittel 22 nicht angreifbar.

### Bezugszeichenliste

- A: Abstand
- D: Dicke
- E: Ebene
- 1: Filmrahmen
- 1i: Innenumfang
- 2: Trägersubstrat
- 3: Film
- 3a: Ablöseabschnitt
- 3b: Befestigungsabschnitt
- 3k: Kontaktierungsflächenabschnitt
- 3s: Klebeschicht
- 4: Produktsubstrat
- 4u: Umfang
- 6: Verbindungsschicht
- 7: Trägersubstrataufnahme
- 8: Vakuumbahnen
- 9: Wanne
- 10: Schallgeber
- 11: Fluid
- 20: Lösungsmittelbehälter
- 21: äußere Umfangswand
- 22: Lösungsmittel

## Patentansprüche

1. Vorrichtung zum Ablösen eines Produktsubstrats (4) von einem mit dem Produktsubstrat (4) durch eine Verbindungsschicht (6) verbundenen Trägersubstrat (2) mittels eines auf einem Filmrahmen (1) montierten flexiblen Films (3), der eine Kleberschicht (3s) zur Aufnahme des Produktsubstrats (4) in einem Kontaktierungsflächenabschnitt (3k) des Films (3) umfasst, wobei der Film (3) in einem den Kontaktierungsflächenabschnitt (3k) umgebenden Befestigungsabschnitt (3b) des Films (3) auf dem Filmrahmen (1) montiert ist, und wobei der Film (3) einen zwischen dem Kontaktierungsflächenabschnitt (3k) und dem Befestigungsabschnitt (3b) liegenden Ablöseabschnitt (3a) umfasst, und wobei die Vorrichtung Ablösemittel zur Bewirkung einer Ablösung des Produktsubstrats (4) vom Trägersubstrat (2) von einem Umfang (4u) des Produktsubstrats (4) her aufweist,
und wobei eine Aufnahmeeinrichtung zur Einleitung einer Kraft in den Filmrahmen (1) ein Kippen des Filmrahmens (1) zulassend ausgebildet ist.

2. Vorrichtung nach Anspruch 1,
**dadurch gekennzeichnet,**
**dass** Verbindungslösemittel zur zumindest partiellen Lösung der durch die Verbindungsschicht (6) bewirkten Verbindung zwischen dem Trägersubstrat (2) und dem Produktsubstrat (4) vorgesehen sind.

3. Vorrichtung nach einem der Ansprüche 1 oder 2,
**dadurch gekennzeichnet,**
**dass** die Verbindungslösemittel Fluidmittel, insbesondere ein die Verbindungsschicht selektiv auflösendes Lösungsmittel (22), zur zumindest partiellen Lösung der Verbindungsschicht (6) umfasst.

4. Vorrichtung nach einem der Ansprüche 1 oder 2,
**dadurch gekennzeichnet,**
**dass** das Verbindungslösemittel mechanische Trennmittel, insbesondere eine Klinge zum Durchschneiden der Verbindungsschicht (6), zur zumindest partiellen Lösung der Verbindungsschicht (6) umfasst.

5. Vorrichtung nach einem der Ansprüche 1 oder 2,
**dadurch gekennzeichnet,**
**dass** das Verbindungslösemittel eine UV-Lichtquelle zur zumindest partiellen Lösung der Verbindungsschicht (6) umfasst.

6. Vorrichtung nach einem der vorhergehenden Ansprüche,
**dadurch gekennzeichnet,**
**dass** das Verbindungslösemittel, insbesondere ausschließlich, im Bereich des Umfangs (4u) wirkend ausgebildet ist.

7. Vorrichtung nach einem der vorhergehenden Ansprüche,
**dadurch gekennzeichnet,**
**dass** der Ablöseabschnitt (3a) außerhalb der Außenkontur des Produktsubstrats (4) liegt und/oder an den Kontaktierungsflächenabschnitt (3k) anschließt.

8. Vorrichtung nach Anspruch 2 oder 3,
**dadurch gekennzeichnet,**
**dass** zur Beaufschlagung der Verbindungsschicht (6) mit Fluidmittel zur Aufnahme des Fluidmittels ein am Trägersubstrat oder einer Trägersubstrataufnahme (7), insbesondere gedichtet, anschlagbarer Lösungsmittelbehälter (20) vorgesehen ist, dessen Oberkante sich zumindest bis zur durch das Produktsubstrat (4) gebildeten Ebene erstreckt.

9. Verfahren zum Ablösen eines Produktsubstrats (4) von einem mit dem Produktsubstrat (4) durch eine Verbindungsschicht (6) verbundenen Trägersubstrat (2) mittels eines auf einem Filmrahmen (1) montierten flexiblen Films (3), der eine Klebeschicht (3s) zur Aufnahme des Produktsubstrats (4) in einem Kontaktierungsflächenabschnitt (3k) des Films (3) umfasst, wobei der Film (3) in einem den Kontaktierungsflächenabschnitt (3k) umgebenden Befestigungsabschnitt (3b) des Films (3) auf dem Filmrahmen (1) montiert ist, und wobei der Film (3) einen zwischen dem Kontaktierungsflächenabschnitt (3k) und dem Befestigungsabschnitt (3b) liegenden Ablöseabschnitt (3a) umfasst, und wobei durch Ablösemittel eine Ablösung des Produktsubstrats (4) vom Trägersubstrat (2) von einem Umfang (4u) des Produktsubstrats (4) her bewirkt wird, und wobei das Produktsubstrat (4) zunächst auf einer Seite abgelöst wird, indem an dieser eine größere Kraft Ff1 eingeleitet wird.

10. Verfahren nach Anspruch 9,
**dadurch gekennzeichnet,**
**dass** die Ablösung des Produktsubstrats (4) konzentrisch vom Umfang (4u) des Produktsubstrats (4) zum Zentrum (4z) des Produktsubstrats (4) erfolgt.
